# EUROPEAN PATENT APPLICATION

(11) **EP 3 675 161 A1**
(43) Date of publication of application: **01.07.2020**
(21) Application number: 18847430.8
(22) Date of filing: 06.08.2018
(51) Int. Cl.: H01L 23/06, H01L 23/04

(54) **PACKAGE FOR ELECTRONIC COMPONENT MOUNTING AND ELECTRONIC DEVICE**

(30) Priority: 25.08.2017 JP 2017162838
(71) Applicant: Kyocera Corporation, Kyoto-shi, Kyoto 612-8501 (JP)
(72) Inventor: OTOMARU, Hidekazu, Kyoto-shi Kyoto 612-8501 (JP)
(74) Representative: Viering, Jentschura & Partner mbB Patent- und Rechtsanwälte
(86) International application number: PCT/JP2018/029486
(87) International publication number: WO 2019/039258

(57) **Abstract**

An electronic component mounting package and an electronic device provide improved reliability. An electronic component mounting package (1) includes a heat sink (6) having a mount area (5) in its middle, on which an electronic component (12) is mountable, a frame (7) installed on the heat sink (6) to surround the mount area (5), a bond (8) joining the heat sink (6) and the frame (7) together, and lead terminals (9) installed on the upper surface of the frame (7) to extend outward from the frame (7). The heat sink (6) includes a metal, and includes a first portion (61) having the mount area (5) and a second portion (62) thinner than the first portion (61). The second portion (62) has a metallic crystal with a crystal grain size smaller than a crystal grain size of a metallic crystal of the first portion (61) in a heat-sink thickness direction.

## Description

### FIELD

The present invention relates to an electronic component mounting package for mounting an electronic component, and an electronic device including the package.

### BACKGROUND

A known electronic component mounting package for mounting an electronic component may include a metal heat sink with an upper surface having a mount area on which an electronic component is mountable, and a frame surrounding the mount area.

In this electronic component mounting package, the frame and the heat sink are joined with a bond. A semiconductor package described in Patent Literature 1 includes a frame surrounding a raised portion in the middle of a heat sink (flange).

### CITATION LIST

### PATENT LITERATURE

Patent Literature 1: Japanese Unexamined Patent Application Publication (Translation of PCT Application) No. 2006-516361

### BRIEF SUMMARY

An electronic component mounting package according to one aspect of the present disclosure includes a heat sink, an insulating member, a bond, and an external connection terminal. The heat sink includes a first portion having a mount area on which an electronic component is mountable, and a second portion thinner than the first portion. The heat sink includes a metal. The second portion has a metallic crystal with a crystal grain size smaller than a crystal grain size of a metallic crystal of the first portion in a heat-sink thickness direction. The insulating member is located on the second portion of the heat sink. The insulating member includes ceramic. The bond joins the second portion and the insulating member together. The external connection terminal is electrically insulated from the heat sink with the insulating member.

An electronic device according to another aspect of the present disclosure includes the electronic component mounting package described above, an electronic component mounted on the mount area, and a connection member to electrically connect the electronic component and the external connection terminal to each other.

### BRIEF DESCRIPTION OF DRAWINGS

The objects, features, and advantages of the present invention will become apparent from the following detailed description and the drawings.
Fig. 1 is a top perspective view of an electronic component mounting package according to an embodiment.
Fig. 2 is an exploded top perspective view of the electronic component mounting package.
Fig. 3 is a cross-sectional view of the electronic component mounting package.
Fig. 4 is a cross-sectional view of an electronic component mounting package according to another embodiment.
Fig. 5 is a cross-sectional view of an electronic device.
Fig. 6A is a cross-sectional scanning ion microscope (SIM) image of a first portion of a heat sink.
Fig. 6B is a cross-sectional SIM image of a second portion of the heat sink.

### DETAILED DESCRIPTION

Embodiments of the present invention will now be described by way of example with reference to the accompanying drawings. Throughout the drawings, an electronic component mounting package and an electronic device are placed on an XY plane defined in a virtual XYZ space. In the present embodiment, the Z-axis direction corresponds to the vertical direction.

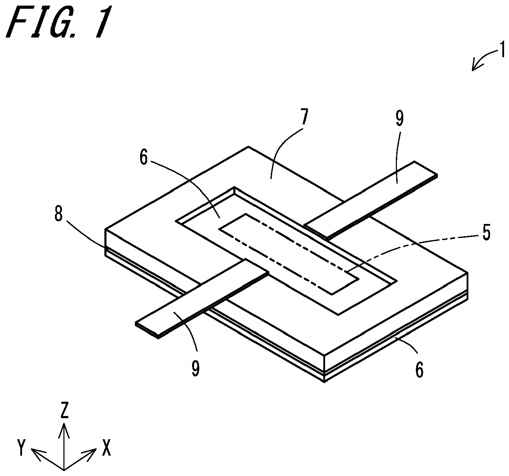

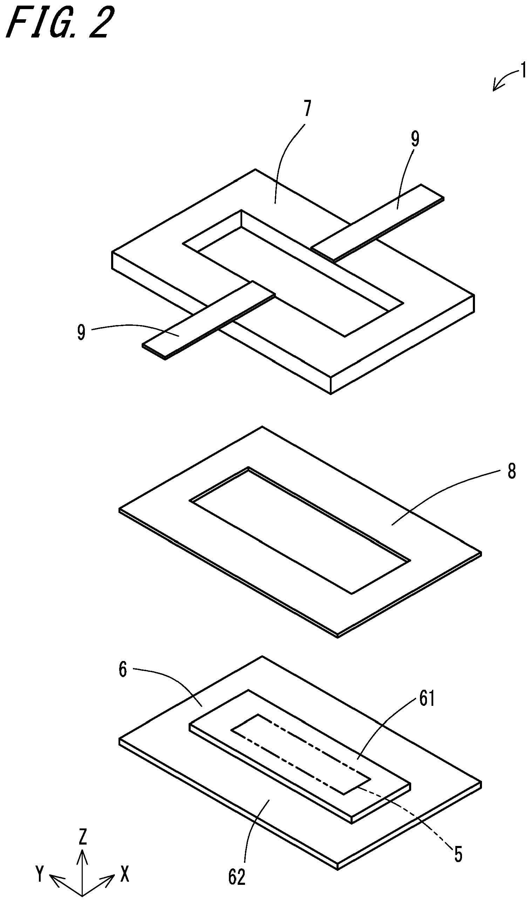

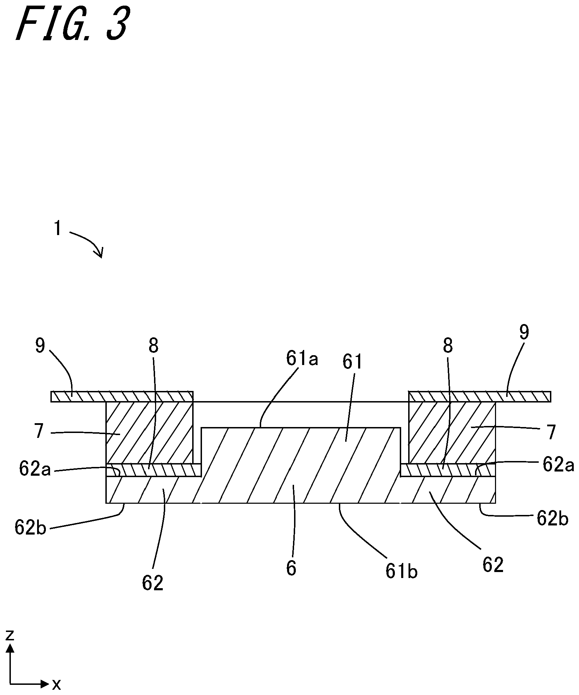

Fig. 1 is a top perspective view of an electronic component mounting package according to the present embodiment. Fig. 2 is an exploded top perspective view of the electronic component mounting package. Fig. 3 is a cross-sectional view of the electronic component mounting package. An electronic component mounting package 1 according to the present embodiment includes a heat sink 6 having a mount area 5 in its middle, on which an electronic component 12 is mountable, a frame-shaped insulating member (hereafter referred to as a frame) 7 installed on the heat sink 6 to surround the mount area 5, a bond 8, which joins the heat sink 6 and the frame 7 together, and lead terminals 9 installed on the upper surface of the frame 7 to extend outward from the frame 7.

The heat sink 6 is formed from a metal, and includes a first portion 61 including the mount area 5, and a second portion 62 thinner than the first portion 61. The heat sink 6 may be, for example, rectangular or disk-shaped in a plan view. The heat sink 6 may be rectangular to have a side of 5 to 50 mm, or may be disk-shaped to have a diameter of 5 to 50 mm. The heat sink 6 is rectangular in the present embodiment. The first portion 61 has a thickness of, for example, 0.5 to 2 mm in the vertical direction. The second portion 62 has a thickness of, for example, 0.1 to 0.5 mm in the vertical direction. The heat sink 6 has any two portions with different thicknesses. In one example, the rectangular first portion 61 and the rectangular second portion 62 may be aligned to each other to share one side forming a step. In another example, the second portion 62 may be on each side of the rectangular first portion 61 and adjacent to the rectangular first portion 61. In the present embodiment, the first portion 61 is rectangular and located in the middle of the heat sink 6, and the second portion 62 surrounds the first portion 61. The heat sink 6 as a whole has a rectangular profile.

The frame 7 is located on the thin second portion 62 to surround the first portion 61. The heat sink 6 dissipates heat generated by the electronic component 12 mounted on the mount area 5, and conducts, for example, heat to the back surface of the heat sink 6 to dissipate heat to air or another cooling member. To increase heat dissipation or thermal conductivity, the heat sink 6 may be thick, as the first portion 61. To increase joining with the frame 7, the heat sink 6 may be thin, as the second portion 62, to reduce warpage or other defects. The heat sink 6 according to the present embodiment combines the first and second portions 61 and 62 with different thicknesses to increase both heat dissipation and joining.

In the heat sink 6 according to the present embodiment, the first portion 61 has a surface 61a including the mount area 5 and a surface 61b opposite to the surface 61a, and the second portion 62 has a surface 62a on which the frame 7 is installed and a surface 62b opposite to the surface 62a. The surface 61b is flush with the surface 62b. In other words, the heat sink 6 has a flat back surface without a step. The back surface of the heat sink 6 comes in contact with another cooling member including an aluminum housing to facilitate dissipation. The flat back surface of the heat sink 6 increases the contact area with the cooling member to enhance dissipation efficiency.

In the heat sink 6 according to the present embodiment, a metallic crystal of the second portion 62 has a crystal grain size smaller, in the heat-sink thickness direction, than a crystal grain size of a metallic crystal of the first portion 61. A metal having a smaller crystal grain size has higher mechanical strength. In other words, the second portion 62 having a smaller crystal grain size in the heat-sink thickness direction has higher strength than the first portion 61. In the present embodiment, bonding the frame 7 to the second portion 62 having a crystal structure with higher strength enhances the bonding strength between the heat sink 6 and the frame 7 serving as an insulating member.

Examples of the metal used for the heat sink 6 include a highly thermally conductive material, including a metal such as copper (Cu), silver (Ag), aluminum (Al), or gold (Au) and an alloy of these metals. Copper is used in the present embodiment to increase thermal conductivity and workability, and reduce costs. Examples of copper include pure copper and a variety of copper alloys containing copper as a main component.

The crystal grain size of the metallic crystal of the heat sink 6 may be measured by any known method, for example, a method for directly measuring the crystal grain size from a cross-sectional image taken parallel to the thickness direction, or an electron backscatter diffraction pattern (EBSD) method. The heat sink 6 undergoes cross-sectional processing with a focused ion beam (FIB) to obtain a scanning ion microscope (SIM) image as a cross-sectional image with a SIM. The obtained SIM image includes different crystal orientations to allow recognition of crystal grains. The crystal grain size in heat-sink thickness direction is also obtained by, for example, image processing. With the EBSD method, a reflection diffraction pattern is obtained from the surface of a metal sample with a scanning electron microscope (SEM). For example, the crystal orientation can be measured from the reflection diffraction pattern to obtain a crystal orientation map, a crystal grain boundary map, a crystal grain distribution map, and other maps of the metal surface (cross section). The crystal grain size of each of the first and second portions 61 and 62 of the heat sink 6 in the heat-sink thickness direction is obtained by measuring the cross section of each of the first and second portions 61 and 62 taken parallel to the thickness direction. A comparison between the obtained crystal grain sizes reveals that the crystal grain size of the metallic crystal of the second portion 62 is smaller than the crystal grain size of the metallic crystal of the first portion 61 in the heat-sink thickness direction.

In this embodiment, r2 < r1, where r1 is the crystal particle grain size of the first portion 61 in the heat-sink thickness direction, and r2 is the crystal particle grain size of the second portion 62 in the heat-sink thickness direction, meaning that the crystal particle grain size of the metallic crystal of the second portion 62 is smaller than the crystal particle grain size of the metallic crystal of the first portion 61 in the heat-sink thickness direction. The crystal grain size r2 of the second portion 62 is smaller than the crystal grain size r1 of the first portion 61. For example, the ratio of the crystal grain size r2 to the crystal grain size r1 (r2/r1) falls within the range of 0.05 to 0.5. The crystal grain sizes r1 and r2 are calculated as follows. With the above measuring method, the crystal grain sizes (the largest length in the cross-sectional image in the thickness direction) in the heat-sink thickness direction are measured for 20 pieces in a single cross-sectional area (50 µm lengthwise × 50 µm crosswise), and the arithmetic mean of these values is obtained as an average grain size for the cross section. Similarly, the average grain size for each cross section is calculated for five cross-sectional areas, and the arithmetic mean of these values is obtained. This processing is performed on the first and second portions 61 and 62 to obtain the crystal grain sizes r1 and r2.

The second portion 62 of the heat sink 6 formed from a metal and the frame 7 formed from ceramic are joined together with the bond 8. The bond 8 may be any material, such as a brazing material, that can join metal and ceramic together. For example, for the heat sink 6 formed from copper, a silver-based brazing material such as a silver brazing material or a Ag-Cu-Sn alloy brazing material is used as the bond 8. Silver in this brazing material diffuses into copper in the heat sink 6, and forms a Ag-Cu alloy. The resultant Ag-Cu alloy has fragility. When the Ag-Cu alloy diffuses in the top layer of the heat sink 6, the alloy easily causes separation or breakage, and lowers the bonding strength.

Other metallic elements in the metal diffuse at a higher speed at the crystal grain boundary than in the crystal grain. The crystal grain boundary can thus be regarded as a diffusion route for these metallic elements. As described above, the second portion 62 of the heat sink 6 has a small crystal grain size in the heat-sink thickness direction. Thus, the second portion 62 substantially has a longer diffusion route, and silver diffusing in copper of the heat sink 6 is more likely to stay at a shallower position. This reduces the likelihood that the Ag-Cu alloy in the second portion 62 diffuses and lowers the bonding strength.

The first and second portions 61 and 62 of the heat sink 6 with different thicknesses may be formed by pressing and/or rolling. Other metal processing such as punching, cutting, etching, and polishing may be performed additionally. For example, a piece having the profile of the heat sink 6 may be punched out from a copper plate, and the peripheral edge may then be pressed or rolled to form the thin second portion 62. The metallic crystal in the second portion 62 can be plastically deformed by partial pressing or rolling. The crystal grain size of the second portion 62 is thus smaller than the crystal grain size of the metallic crystal of the first portion 61 in the heat-sink thickness direction.

After punching, the peripheral edge surface has one end portion in the thickness direction having large surface roughness (rough surface portion). When the second portion 62 has a rough surface portion on the surface 62a on which the frame 7 is installed, the bond 8 softened to join the frame 7 and the heat sink 6 is less likely to flow outward with the rough surface portion, forming a meniscus near the rough surface portion. The bond 8 forming a meniscus improves the stress relaxation characteristics, and improves the joining reliability between the frame 7 and the heat sink 6. When the second portion 62 has a rough surface portion on the surface 62b opposite to the surface 62a on which the frame 7 is installed, the solder softened to join the heat sink 6 and another cooling member such as an aluminum housing is less likely to flow outward with the rough surface portion, forming a meniscus near the rough surface portion. The solder forming a meniscus improves the stress relaxation characteristics, and improves the joining reliability between the heat sink 6 and the cooling member.

The frame 7 is an insulating member formed from ceramic such as sintered alumina (Al₂O₃), sintered aluminum nitride (AlN), sintered mullite (3Al₂O₃, 2SiO₂), and glass ceramics, which is selected from materials having a coefficient of thermal expansion approximate to the coefficient of thermal expansion of the heat sink 6. In the present embodiment, the frame 7 is formed from sintered alumina (Al₂O₃).

For the frame 7 formed from, for example, sintered alumina, an additive such as an organic binder, a solvent, a plasticizer, or a dispersant is added as appropriate to the powder of a raw material such as alumina, silicon oxide (SiO₂), magnesium oxide (MgO), or calcium oxide (CaO), and the mixture of these is then kneaded to obtain slurry. The slurry is then shaped into a sheet using, for example, a doctor blade or by calendering to obtain a ceramic green sheet (ceramic raw sheet). The ceramic green sheet then undergoes punching as appropriate. Multiple ceramic green sheets prepared in this manner are stacked one on another, and are then fired at a temperature of about 1600 °C.

The lead terminals 9 are strip-shaped external connection terminals formed from a metal such as copper, a copper alloy, an iron-nickel-cobalt alloy, or an iron-nickel alloy. The lead terminals 9 each have one end in the longitudinal direction connected to the frame 7, and extend outward from the frame 7. The lead terminals 9 are electrically insulated from the heat sink 6 by the frame 7. The lead terminals 9 may be located on the upper surface of the frame 7 as in the present embodiment or may extend through the frame 7.

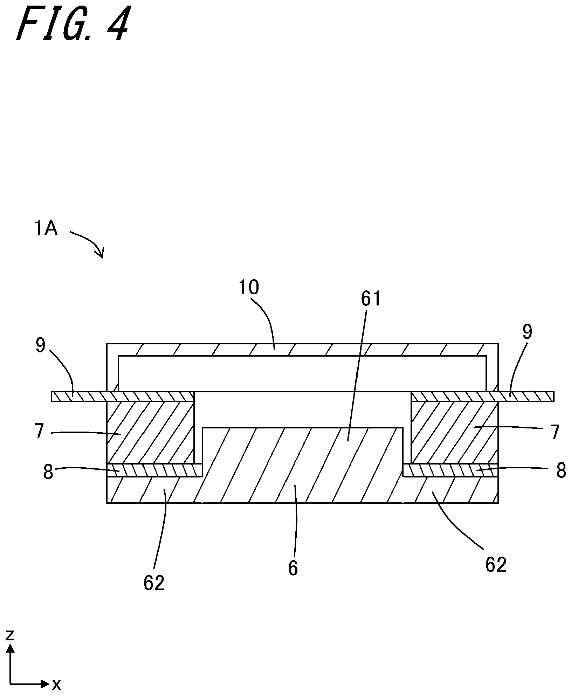

Fig. 4 is a cross-sectional view of an electronic component mounting package according to another embodiment. An electronic component mounting package 1A according to the present embodiment further includes a lid 10. The lid 10 protects the electronic component mounted on the electronic component mounting package 1A, and provides airtightness and water-tightness inside the package (in the space defined by the frame 7, the heat sink 6, and the lid 10). The lid 10 may be formed from any material such as ceramics, glass, resin, or a combination of any of these materials.

The lid 10 may have any shape that allows the package to accommodate an electronic component, such as a flat plate member or a member having a recessed inner surface. The lid 10 is joined to the upper surface of the frame 7. A bond that joins the lid 10 and the frame 7 may be selected as appropriate in accordance with the material of the lid 10.

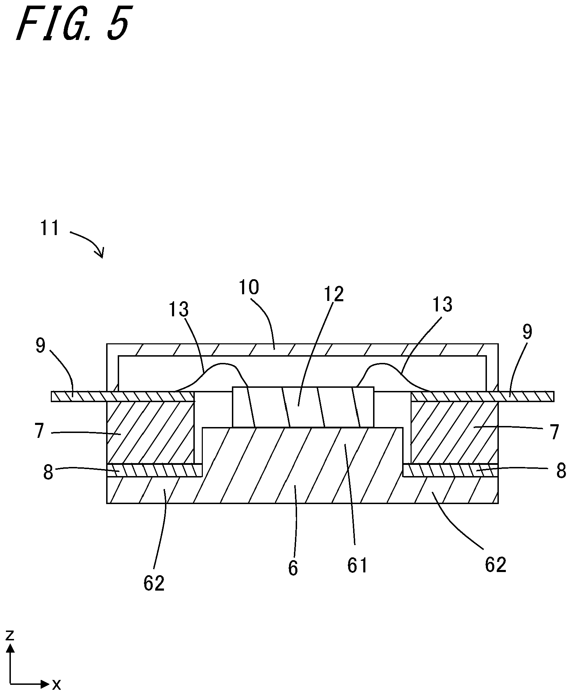

Fig. 5 is a cross-sectional view of an electronic device. An electronic device 11 according to the present embodiment includes the electronic component mounting package 1 or 1A, the electronic component 12 such as a semiconductor device mounted on the mount area 5, and bonding wires 13, which are connectors that electrically connect the electronic component 12 and the lead terminals 9.

The electronic device 11 according to the present embodiment is obtained by mounting an intended electronic component 12 on the mount area 5 of the electronic component mounting package 1 or 1A and electrically connecting the mounted electronic component 12 and the lead terminals 9 with the bonding wires 13. The electronic component 12 and the heat sink 6 may also be electrically connected with the bonding wires 13.

The electronic device 11 may also have the heat sink 6 fixed to the surface of a cooling member such as an aluminum block. Heat generated by the electronic component 12 may be transferred through the heat sink 6 and then through the cooling member to be dissipated from the cooling member or transferred to another cooling member. The heat sink 6 (electronic component mounting package 1 or 1A) may be fixed to the cooling member with a bond such as the solder described above.

### Examples

Electronic component mounting packages having the same structure as in the embodiment illustrated in Figs. 1 to 3 were prepared. The heat sink 6 was formed from a copper plate with a thickness of 1 mm punched out in advance into a rectangle (20 mm lengthwise × 10 mm crosswise). The outer periphery (2 mm wide) of the copper plate was pressed to have a thickness of 0.2 mm to form the first portion 61 in the middle portion with a thickness of 1 mm and the second portion 62 in the surrounding portion surrounding the first portion 61. The frame 7 formed from sintered alumina (Al₂O₃) was joined to the second portion 62 with a silver brazing material used as the bond 8. The lead terminals 9 were then joined to the frame 7 to obtain an electronic component mounting package.

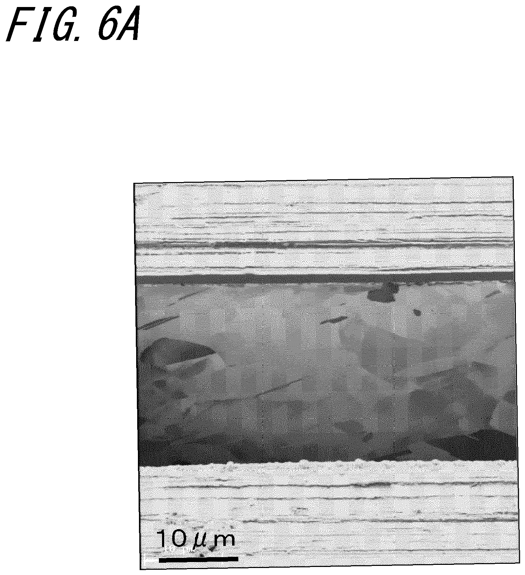

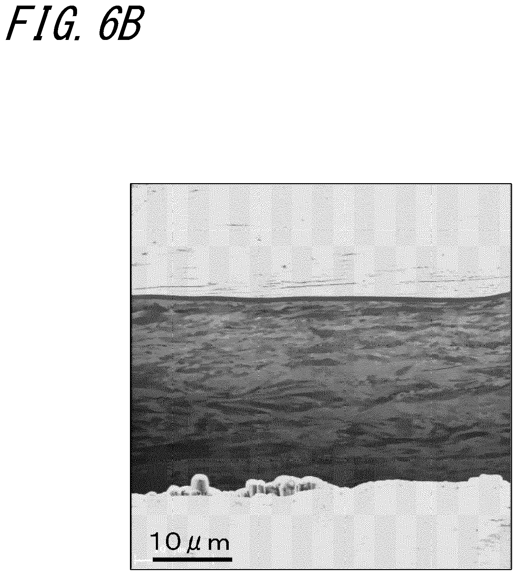

SIM images for the first and second portions 61 and 62 of the heat sink 6 were obtained through cross-sectional processing with an FIB. Fig. 6A is a cross-sectional SIM image of the first portion of the heat sink, and Fig. 6B is a cross-sectional SIM image of the second portion of the heat sink. A focused ion beam processing observation system (FB-2100: Hitachi High-Technologies Corporation) was used to perform cross-sectional processing and obtain the SIM images under cross-sectional processing conditions of 40 kV and 4 to 78 nA and the cross-sectional observation condition of 3000 magnifications.

The obtained SIM images reveal that the crystal grain size of the second portion 62 is smaller in the heat-sink thickness direction than the crystal grain size of the first portion 61. The ratio (r2/r1) of the crystal grain size r2 to the crystal grain size r1 in the present example was 0.21.

The present invention can be embodied in various other forms not departing from the spirit or main features of the invention. The above-described embodiments are thus mere examples in all respects. The scope of the present invention is described in the scope of claims without being restricted to the description. Modifications and changes pertaining to the scope of claims fall within the scope of the present invention.

### Reference Signs List

- 1, 1A: electronic component mounting package
- 5: mount area
- 6: heat sink
- 7: frame
- 8: bond
- 9: lead terminal
- 10: lid
- 11: electronic device
- 12: electronic component
- 13: bonding wire
- 61: first portion
- 62: second portion

## Claims

1. An electronic component mounting package, comprising:
a heat sink including a first portion and a second portion thinner than the first portion, the heat sink comprising a metal, the first portion having a mount area on which an electronic component is mountable, the second portion having a metallic crystal with a crystal grain size smaller than a crystal grain size of a metallic crystal of the first portion in a heat-sink thickness direction;
an insulating member located on the second portion of the heat sink, the insulating member comprising ceramic;
a bond joining the second portion and the insulating member together; and
an external connection terminal electrically insulated from the heat sink with the insulating member.

2. The electronic component mounting package according to claim 1, wherein
a surface of the first portion of the heat sink opposite to a surface having the mount area is flush with a surface of the second portion of the heat sink opposite to a surface on which the insulating member is located.

3. The electronic component mounting package according to claim 1 or claim 2, wherein
the metal includes copper.

4. The electronic component mounting package according to any one of claims 1 to 3, wherein
the first portion is located in a middle of the heat sink, and the second portion surrounds the first portion, and
the insulating member is frame-shaped.

5. The electronic component mounting package according to claim 4, further comprising:
a lid configured to cover the frame-shaped insulating member.

6. An electronic device, comprising:
the electronic component mounting package according to any one of claims 1 to 5;
an electronic component mounted on the mount area; and
a connection member to electrically connect the electronic component and the external connection terminal to each other.
